# EUROPEAN PATENT APPLICATION

(11) **EP 1 701 146 A1**
(43) Date of publication of application: **13.09.2006**
(21) Application number: 06251215.7
(22) Date of filing: 07.03.2006
(51) Int. Cl.: G01L 19/02

(54) **Zero point correction circuit of load meter**

(30) Priority: 09.03.2005 JP 2005065306
(71) Applicant: Riken Optech Corporation, Shinagawa-ku Tokyo, 140-8533 (JP)
(72) Inventor: Moriya, Hiroyuki, Shinagawa-ku Tokyo 140-8533 (JP)
(74) Representative: Lucas, Brian Ronald

(57) **Abstract**

The present invention relates to a zero point correction circuit for a load meter used for a press machine or the like, and more particularly to a configuration with which a zero point correction is made a plurality of times after a predetermined amount of time elapses, after press processing is performed, and a zero point correction value is set by calculating an average value of measured values. The predetermined amount of time is measured, for example, with an internal timer or the like, a sampling process is performed after the predetermined amount of time elapses, and an average value of sampled values is calculated and set as a zero point correction value, whereby an accurate zero point correction value can be obtained.

## Description

### Background of the Invention

### Field of the Invention

The present invention relates to a zero point correction circuit of a load meter, which is used for a press machine or the like.

### Description of the Related Art

A load meter for displaying a load by detecting the load generated by a press machine with the use of a sensor when the press machine presses a material is provided. For example, Japanese Patent Publication (No. HEI11-114641) discloses a technique with which a distortion sensor is provided for a machine, a strain is detected when a press machine is driven, a load is calculated from the output of the sensor, and the calculated load is displayed on a load meter.

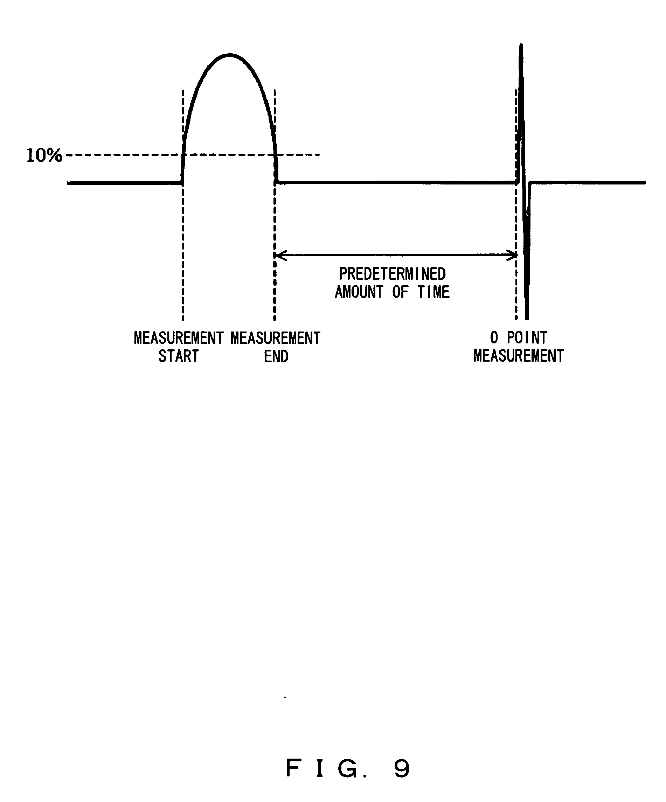

Such a load meter used for a press machine is intended to detect and display a load generated by the machine. At this time, the detected data and the load generated by the press machine must precisely match. For this reason, a zero point correction of a load meter is made every time a press machine is driven, in order to accurately measure a sensor output. For example, a timing signal is fed from a rotary cam of a press machine every time the press machine is driven, and a zero point correction of a load meter is made. Fig. 9 shows the timing of a conventional zero point correction. As shown in this figure, after a measurement is made, a zero point measurement is made after a predetermined amount of time elapses.

With the conventional method, however, the timing signal is fed from the rotary cam at predetermined timing after the press machine is driven, and the zero point correction cannot be accurately made if a sensor signal is not stable when a strain is detected. Especially, the sensor detects a strain when a ram descends in the press machine to process a material. Also when the ram reaches a top dead center, the press machine is strained. Accordingly, a detection signal from the sensor does not become stable, and the zero point correction cannot be accurately made.

### Summary of the Invention

It is therefore an object of the present invention is to provide a configuration with which after press processing is performed, a zero point correction is made a plurality of times after a predetermined amount of time elapses, and a zero point correction value is set by calculating an average value of measured values.

The present invention is a system having a load sensor attached to a press machine, and a load meter for measuring a load based on a detection signal of the load sensor, in order to overcome the above described problem.

The load meter can be implemented by providing a zero point correction circuit comprising: measuring means for measuring an elapse of predetermined timing time after the press machine is driven; sampling means for performing a sampling process of a zero point correction a plurality of times when the measuring means measures the elapse of the predetermined timing time; calculating means for calculating an average value of the sampling process performed the plurality of times; and setting means for setting a zero point correction value based on a calculation result.

The number of times that the sampling process is performed is, for example, ten times. With such a configuration, an accurate zero point correction can be made.

Additionally, the present invention can be implemented by providing a zero point correction program, which can be executed by a computer, and is used by a system having a load sensor attached to a press machine and a load meter for measuring a load based on a detection signal of the load sensor, for causing the computer to execute: a measurement process for measuring an elapse of predetermined timing time after the press machine is driven; a sampling process for performing a sampling process of a zero point correction a plurality of times when the elapse of the predetermined timing time is measured; a calculation process for calculating an average value of the sampling process performed the plurality of times; and a setting process for setting a zero point correction value based on a calculation result. Also with such a configuration, an accurate zero point correction can be made.

### Brief Description of the Drawings

Fig. 1 shows a configuration of a zero point correction circuit of a load meter according to a preferred embodiment;
Fig. 2 shows an example of the zero point correction circuit within the load meter;
Fig. 3 is a time chart of a zero point correction made by a controlling unit;
Fig. 4 shows a specific example of the preferred embodiment, in which a vertical axis represents a load [tf] corresponding to a detection signal, and a horizontal axis represents an elapsed amount of time [t] ;
Fig. 5 shows specific measurement results;
Fig. 6 shows measurement results of a sensor attached to the left side of the press machine;
Fig. 7 shows measurement results of a sensor attached to the right side of the press machine;
Fig. 8 is a time chart explaining a zero point correction made by using external timing; and
Fig. 9 explains a conventional example.

### Description of the Preferred Embodiments

Preferred embodiments according to the present invention are described in detail below with reference to the drawings.

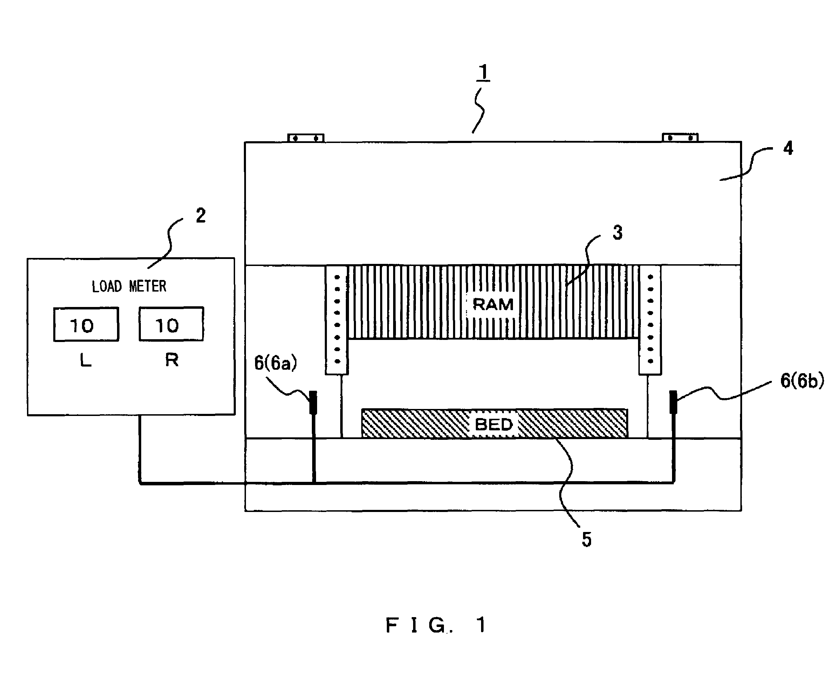

Fig. 1 shows a configuration of a system for making a zero point correction of a load meter according to a preferred embodiment. In this figure, this system is configured by a press machine 1 and a load meter 2. The press machine 1 is configured by a ram for a press 3, which applies a desired pressure to a material not shown with ascending/descending operations, a driving unit 4 for causing the ram 3 to perform the ascending/descending operations, and a base 5 on which a bottom pattern is placed. On the ram 3, a top pattern not shown is placed.

The driving unit 4 is fed driving force from a rotary machine not shown, and drives the ram 3 upward and downward. Additionally, a sensor 6 is attached to the press machine 1, and detects a strain which occurs in the press machine when the ram 3 descends and a material is processed. The sensor 6 outputs a signal corresponding to the detected strain to the load meter 2. For the load meter 2, the sensitivity of the sensor using a load cell is adjusted at the time of attachment.

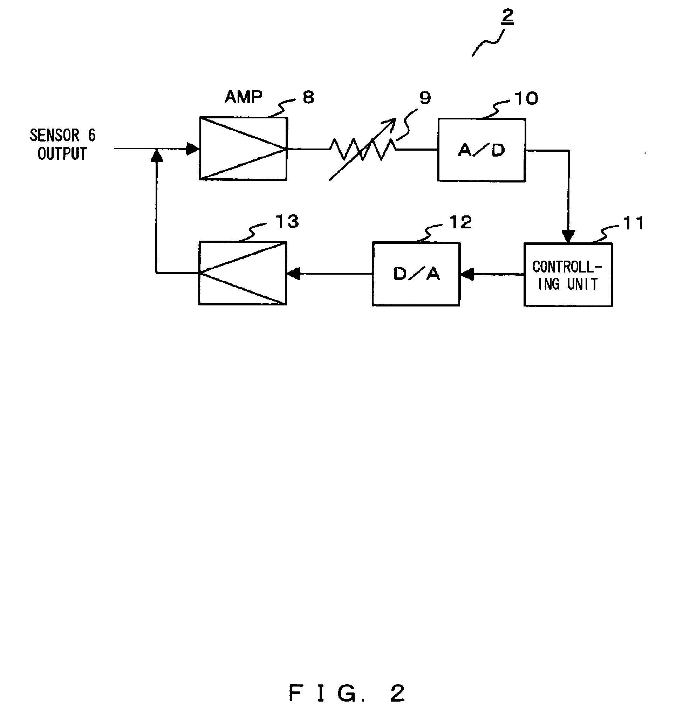

Fig. 2 shows an example of a zero point correction circuit within the load meter 2. As shown in this figure, the detection signal based on the strain detected by the sensor 6 is fed to an amplifier 8, which then performs a predetermined signal amplification process. The signal amplified by the amplifier 8 is regulated by a regulator 9, and fed to an analog/digital converter (A/D converter) 10.

For data converted into digital data by the A/D converter 10, a zero point correction is made by a controlling unit 11. This zero point correction will be described in detail later. The signal for which the zero point correction is made is fed to a digital/analog converter (D/A converter) 12, converted into an analog signal, and added to the signal fed from the sensor 6.

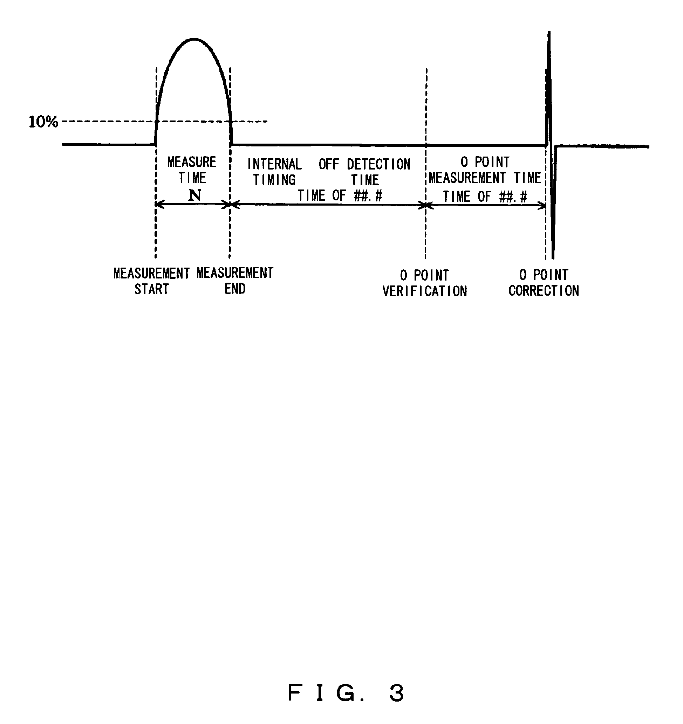

Fig. 3 is a time chart of the zero point correction made by the controlling unit 11. When the ram 3 of the press machine 1 descends and a material is pressed as described above, the sensor 6 detects the strain occurring in the press machine 1, and outputs a detection signal to the load meter 2. In the example shown in Fig. 3, measurement starts when a signal the level of which increases to a threshold value of 10 percent or more from the zero level before adjustment is input, and ends when the signal level decreases to the threshold value of 10 percent or less from the zero level (for example, measurement time is N)

In this preferred embodiment, off time of internal timing is measured from the time point at which the measurement ends. For example, if internal timing off time of ##.# elapses, a reference point of the zero point correction is verified, and an elapse of a zero point determination time is waited from the time point of the verification. In this preferred embodiment, this time is assumed to be ##.# similar to the above described off time. This time is, for example, 0.01 to 2.50 seconds.

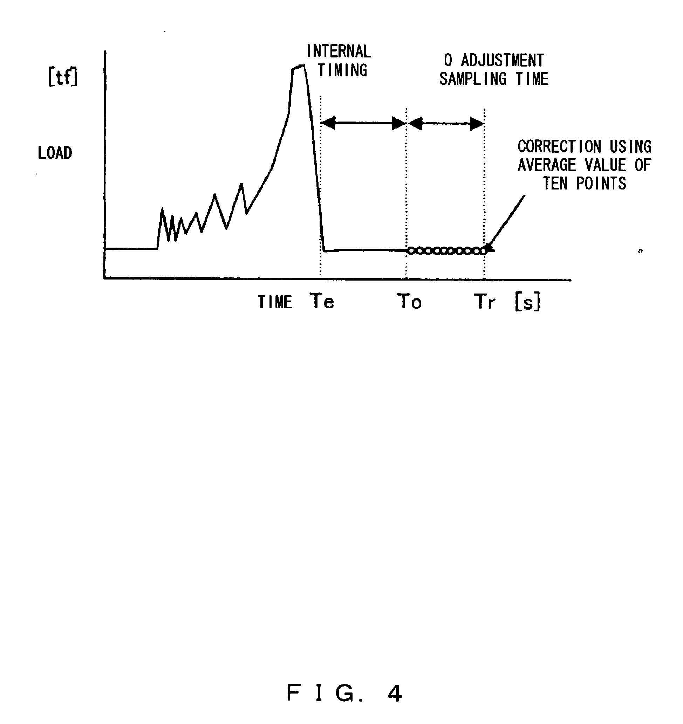

Fig. 4 shows a specific example of this preferred embodiment. In this figure, the vertical axis represents a load [tf] corresponding to a detection signal, whereas the horizontal axis represents an elapsed amount of time [t] . Additionally, a time Te indicates a time point at which the measurement ends, a time To indicates a reference point of the zero point correction, and a time Tr indicates a time point at which the zero point correction ends.

Firstly, the press machine 1 is driven, and the sensor 6 detects a strain occurring in the press machine 1. Thereafter, when the output of the sensor 6 reaches a threshold value of 10 percent or less of the maximum value (timing of the time Te), internal timing is measured, and the reference point (timing of the time To) of the zero point correction is reached. Thereafter, the controlling unit 1 makes the zero point correction, and samples the zero point ten times. For example, if the sampling is made every 0.1 second, the sampling completes 10 times in 1.0 second, and an average value is immediately calculated.

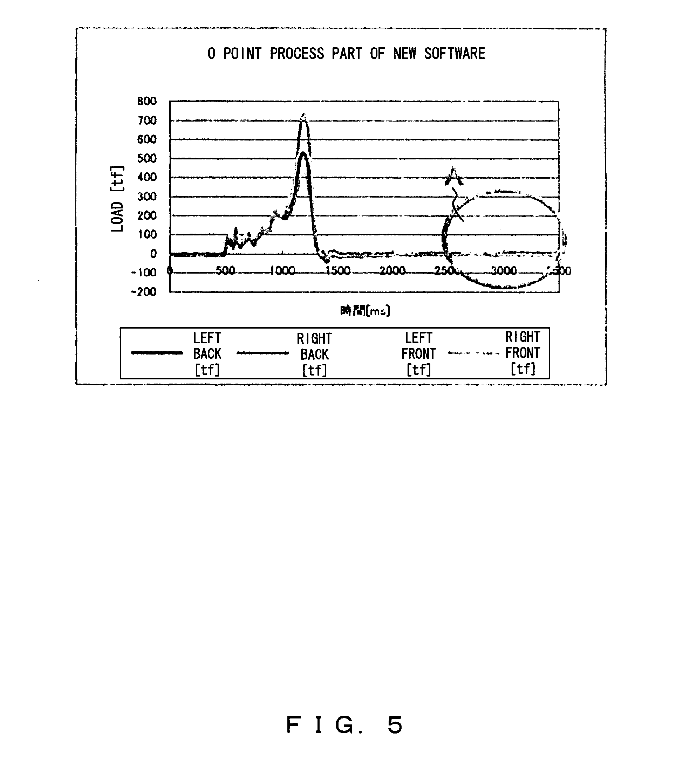

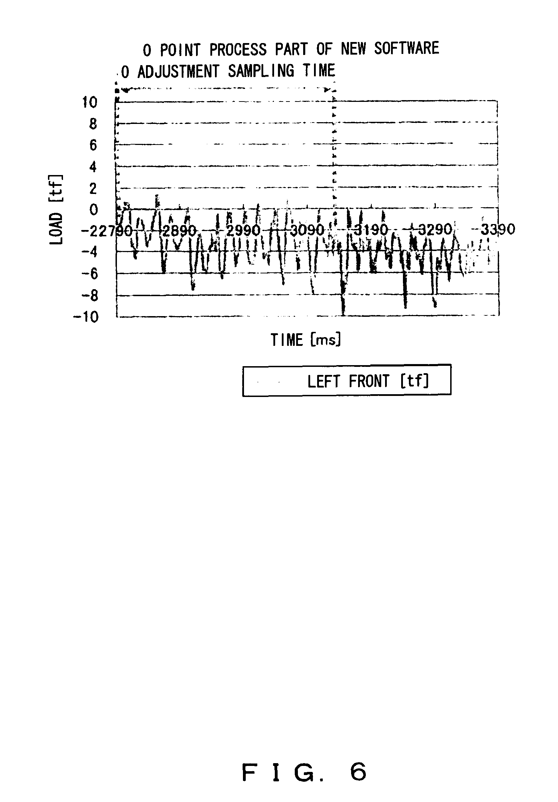

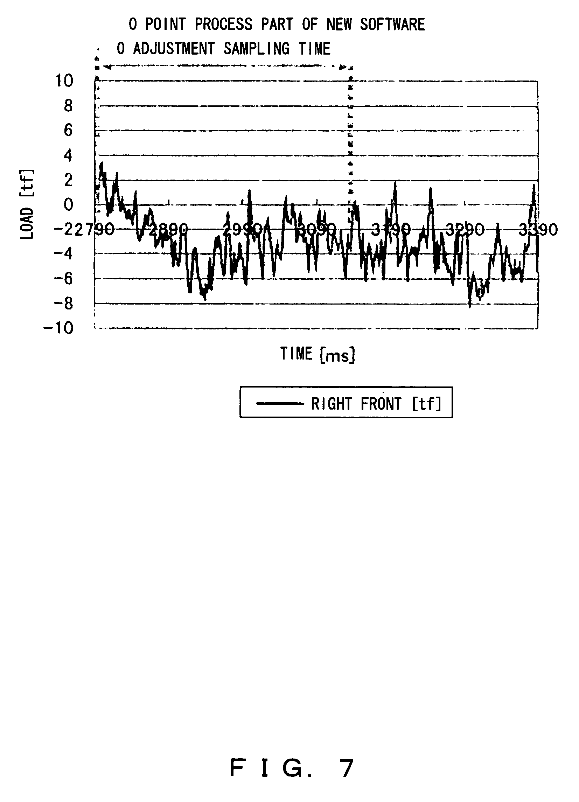

Fig. 5 shows specific measurement results. Figs. 6 and 7 are enlarged views of an A portion indicated by a circle shown in Fig. 5. Fig. 6 shows the measurement results of a sensor 6 (6a) attached to the left side of the press machine 1, whereas Fig. 7 shows the measurement results of a sensor 6 (6b) attached to the right side of the press machine 1.

The process is performed as described above, whereby the zero point correction value becomes the average value of measured values of the sampling process performed ten times, and an accurate offset value can be obtained. Furthermore, the reference point (the timing of the time To) of the zero point correction is set after the internal timing is measured from the timing of the time Te, and the zero point correction process is performed thereafter. As a result, the output of the sensor 6 becomes stable, and a more accurate offset value can be obtained.

According to the above described preferred embodiment, the time during which the sampling is made ten times is assumed to be 1 second. However, a time during which the sampling is made once may be set to 0.1 second or less, and the time during which the sampling is made ten times may be set to 1 second or less. Or, the time during which the sampling is made once may be set to 0.1 second or more, and the time during which the sampling is made ten times may be set to 1 second or more. Besides, the number of times that the sampling is made is not limited to ten times. For example, the number of times may be less than ten times, or ten times or more.

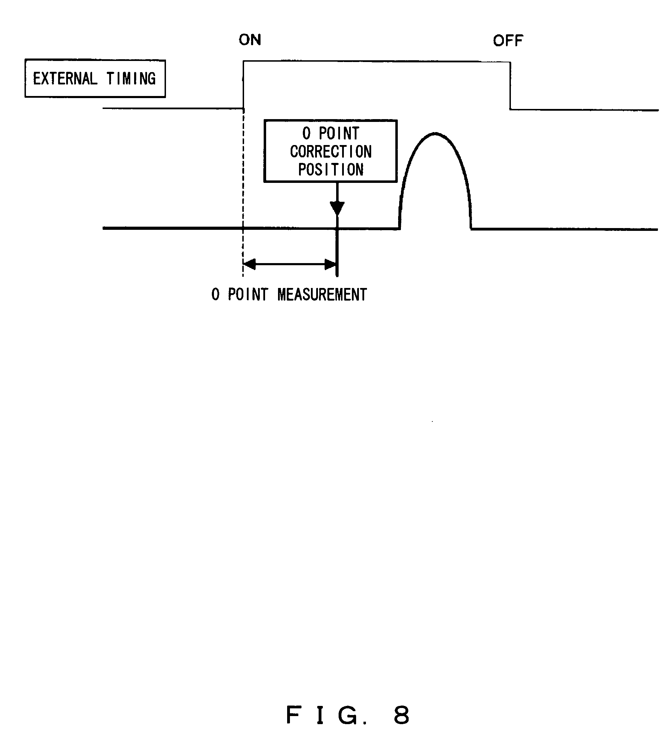

Additionally, although the above described preferred embodiment refers to the process performed by using the internal timing, the process may be performed by using an external timing signal as shown in Fig. 8. For example, a signal from a cam installed in the above described press machine 1 is received, the sampling is made from an ON position shown in this figure for a preset time such as 0.1 to 2.5 seconds, and the zero point correction is made after the preset time elapses. Also with such a configuration, the zero point correction can be made in a state where the output is stable. As a result, an accurate offset value can be obtained.

According to the present invention, after the measurement ends, the sampling process is performed a plurality of times after a predetermined amount of time elapses, and an average value of the sampling process is calculated, whereby an accurate zero point correction value can be obtained.

## Claims

1. A zero point correction system having a load sensor(6) attached to a press machine(1), and a load meter (2) for measuring a load based on a detection signal of the load sensor (6), the load meter(2) comprising:
measuring means for measuring an elapse of a predetermined timing time after the press machine(1) is driven;
sampling means for performing a sampling process of a zero point correction a plurality of times when said measuring means measures the elapse of the predetermined timing time;
calculating means for calculating an average value of the sampling process performed the plurality of times; and
setting means for setting a zero point correction value based on a calculation result.

2. The zero point correction system according to claim 1, wherein
the number of times that the sampling process is performed is ten times.

3. A system having a load sensor(6) attached to a press machine (1), and a load meter(2) for measuring a load based on a detection signal of the load sensor (6) , the load meter(6) comprising:
sampling means for performing a sampling process of a zero point correction a plurality of times after a timing signal output from the press machine (1) is fed;
driving means for performing a driving process of the press machine after the sampling process is performed;
calculating means for calculating an average value of the sampling process performed the plurality of times; and
setting means for setting a zero point correction value based on a calculation result.

4. The zero point correction system according to claim 3, wherein
the number of times that the sampling is made is ten times.

5. A program, which is used by a system having a load sensor(6) attached to a press machine(1) and a load meter (2) for measuring a load based on a detection signal of the load sensor (6), and can be executed by a computer, for causing the computer to execute:
a measuring process for measuring an elapse of a predetermined timing time after the press machine is driven;
a sampling process for performing a sampling process of a zero point correction a plurality of times when the elapse of the predetermined timing time is measured;
a calculating process for calculating an average value of the sampling process performed the plurality of times; and
a setting process for setting a zero point correction value based on a calculation result.
